# EUROPÄISCHE PATENTANMELDUNG

(11) **EP 3 617 724 A1**
(43) Veröffentlichungstag der Anmeldung: **04.03.2020**
(21) Anmeldenummer: 18191952.3
(22) Anmeldetag: 31.08.2018
(51) Int. Cl.: G01R 31/34

(54) **ÜBERWACHUNG EINER ELEKTRISCHEN MASCHINE**

(71) Anmelder: Siemens Aktiengesellschaft, 80333 München (DE)
(72) Erfinder: Bormann, Ulf, 90518 Altdorf (DE); Klos, Hans-Henning, 91249 Weigendorf (DE); Scheibner, Dirk, 90473 Nürnberg (DE); Schimmer, Jürgen, 90473 Nürnberg (DE); Zettner, Jürgen, 90587 Veitsbronn (DE)

(57) **Zusammenfassung**

Bei einem Betriebsverfahren eines Antriebsstranges (1), wobei der Antriebsstrang (1) zumindest einen Stromrichter (2) aufweist, wird ein erstes Signal (11), welches vom Takt des Stromrichters (2) abhängt, aufgenommen, wobei ein zweites Signal (12), welches von einer Drehzahl (3) einer dynamoelektrischen Maschine (4) abhängt, auch aufgenommen wird, wobei eine Übertragungsfunktion (5) einer Regelstrecke (6) ermittelt wird, wobei die Regelstrecke (6) den Antriebsstrang (1) aufweist, wobei eine Änderung der Übertragungsfunktion (5) erkannt wird.

## Beschreibung

Die Erfindung betrifft die Überwachung einer elektrischen Maschine unter Berücksichtigung einer Übertragungsfunktion. Die elektrische Maschine betrifft dabei beispielsweise eine Maschine in der Schwerindustrie, im Bergbau, im Schiffsbau, etc. Die Maschine betrifft dabei auch eine Antriebsmaschine und oder einem Generator insbesondere in der Schwerindustrie, im Bergbau und oder im Schiffbau.

Um beispielsweise den Betriebszustand einer elektrischen Maschine zu erfassen wird ein System zur deren Überwachung eingesetzt. Ein derartiges System kann auch als Condition Monitoring (CM) System bezeichnet werden. Das CM elektrischer Antriebsstränge bezieht sich beispielsweise auf die Früherkennung von Lagerschäden, da diese eine der häufigsten Ausfallursachen sind. Beispielsweise gibt es vibrationsbasierte Verfahren, bei denen Lagerfehler anhand der gemessenen Maschinenvibration detektiert werden können. Des Weiteren gibt es die Diagnose durch Messung von Körperschall, die darauf basiert, dass mechanische Fehler außer Vibrationen auch eine erhöhte Geräuschemission verursachen.

Weiterhin ist eine Diagnosetechnik zur Erkennung von Motorfehlern durch Messung der Maschinenströme, kurz als "MCSA" für "Motor current signatur analysis" bezeichnet, bekannt. Der Vorteil der MCSA gegenüber der Vibrationsanalyse besteht darin, dass keine kostspieligen Sensoren außer ohnehin verbauter Stromsensoren (insbesondere im Falle einer Umrichterkopplung) erforderlich sind. Hierzu wird beispielsweise auf einen Artikel von J. R. Stack, T. G. Habetler und R. G. Harley verwiesen: "Bearing fault detection via autoregressive stator current modeling" (IEEE Transactions on Industry Applications, Vol. 40, No. 3, May/June 2004).

Die Anwendung der MCSA bei der Diagnose von Lagerfehlern ist allerdings insofern problematisch, als dass die Fehlersignale nur vergleichsweise kleine Amplituden besitzen und deren Erkennung im Stromspektrum daher schwierig ist. Wird die MCSA Methode auf Motorlager von Asynchronmaschinen, die in einem mittleren Leistungsbereich eine sehr kleine Luftspaltbreite (zwischen Stator und Rotor) von nur einigen Zehntel Millimetern aufweisen angewandt ist die Diagnose basierend auf der Änderung der magnetischen Flussdichte im Luftspalt der Maschine im Vergleich zu Synchronmaschinen begünstigt.

Aus der EP 2 244 080 A1 ist ein Verfahren zur Zustandsüberwachung bekannt. Es werden im Rahmen eines mechanischen Antriebsverbunds bestimmte Funktionen erfüllende Lager permanenterregter Synchronmaschinen überwacht. Die Zustandsüberwachung wird antriebsbasiert mittels wenigstens einer Frequenzganganalyse durchgeführt. Dieses System des mechanischen Antriebsverbunds wird zur Frequenzganganalyse mittels eines Pseudo-Rausch-Binär-Signals (PRBS) angeregt.

Auch aus der Dissertation von S. Villwock mit dem Titel "Identifikationsmethoden für die automatisierte Inbetriebnahme und Zustandsüberwachung elektrischer Antriebe", Universität Siegen, 2007, ist das Prinzip einer Überwachung eines Antriebsstranges mittels einer Frequenzganganalyse bekannt.

Aus einer Veröffentlichung von Botao Miaoet al. sind weitere Beispiele einer Systemidentifikation bei einem Antriebsstrang bekannt: "A Modified Cross-Correlation Method for System Identification of Power Converters with Digital Control", 2004. Auch hier werden hierfür PRBS eingesetzt.

Elektrische Maschinen können Antriebslösungen betreffen, welche beispielsweise mehreren Unterkomponenten aufweisen. In einer einfachen Konstellation weist eine Antriebslösung beispielsweise einen Motor, eine Kupplung und ein angetriebenes System z.B. mit Riemen, Kugelumlaufspindel, Walze, Prozesstechnischer Fluidkreis usw., auf. Die Unterkomponenten können ein schwingfähiges System ausbilden. Ein geregelter Antrieb ist demnach derart auszulegen, dass ein Regler bzw. ein Regelmodell mit den entsprechenden Parametern so eingestellt ist, dass kein instabiler Zustand des Systems auftritt. So sind in der Praxis durch geeignete Wahl insbesondere der PID Parameter ungeeignete Betriebspunkte in der Nähe von Resonanzen zu vermeiden. Hierzu können heuristische Methoden genutzt werden. In der Automatisierungstechnik bzw. in der Regelungstechnik werden heuristische Methoden zur Dimensionierung eines Reglers, die also ohne mathematisches Modell der Regelstrecke auskommen, häufig auch als Faustformelverfahren bezeichnet. Statt einer Modellbildung sind so beispielsweise Experimente an der zu regelnden Anlage vorzunehmen um eine Regelung einzustellen. Ein Beispiel hierfür ist die Methode von Ziegler und Nichols, welche ein heuristisches Verfahren zur Bestimmung von Reglerparametern ist. Dabei wird eine Sprungantwort einer Regelstrecke mit Wendetangente zur Bestimmung von K (Verstärkung) Tᵤ (Verzugszeit) und T_{g} (Ausgleichszeit) verwendet.

In einigen Fällen begegnet man der Resonanzproblematik in der Antriebstechnik mit einer reduzierten Reglerverstärkung, wobei dann die mögliche Dynamik des Antriebs nicht ausgenutzt wird. Fortgeschrittene Regelstrukturen setzen exakte Kenntnisse der Strecke und deren Parameter voraus. Die Anzahl an einzustellenden Regelparametern ist dementsprechend höher. Die Systemparameter können aus den Konstruktionsdaten bekannt sein oder bei der Inbetriebsetzung experimentell ermittelt werden. Die Strecke kann sich aber im Laufe der Zeit verändern, wobei die unbemerkt bleiben kann bzw. eine Verschlechterung der Regeldynamik hervorruft.

Eine Aufgabe der vorliegenden Erfindung ist es, ein verbessertes Condition Monitoring für eine Maschine, insbesondere für einen Antriebsstrang zu ermöglichen.

Eine Lösung der Aufgabe ergibt sich nach einem Verfahren nach Anspruch 1 bzw. nach einer Vorrichtung nach Anspruch 12. Jeweilige Ausgestaltungen ergeben sich gemäß der Ansprüche 2 bis 10 bzw. 13.

Bei einem Betriebsverfahren eines Antriebsstranges (also einem Verfahren zum Betrieb eines Antriebsstranges), wobei der Antriebsstrang zumindest einen Stromrichter aufweist, wird ein erstes Signal, welches vom Takt des Stromrichters abhängt aufgenommen, wobei auch ein zweites Signal, welches von einer Drehzahl einer dynamoelektrischen Maschine abhängt, aufgenommen wird, wobei eine Übertragungsfunktion einer Regelstrecke ermittelt wird, wobei die Regelstrecke den Antriebsstrang aufweist, wobei eine Änderung der Übertragungsfunktion erkannt wird. Diese Übertragungsfunktion kann in einer Ausgestaltung des Verfahrens regelmäßig ermittelt und überwacht werden. Das erste Signal ist beispielsweise ein Signal eines Magnetfeld- und/oder Vibrations- und/oder Drehzahl- und/oder Stromsensors bzw. dessen Spektrum. Das zweite Signal ist beispielsweise ein Signal, das von einer Drehzahländerung abhängt bzw. diese bewirkt. Solche Signale treffen, Weise Gleichlaufschwankungen, Sprungfunktionen, Hochlauf Funktionen, Drehzahlsprünge und/oder ein aufmodulierter PRBS Strom. Der Antriebsstrang weist dabei insbesondere zumindest eine elektrische rotatorische Maschine auf, welche als Motor und/oder Generator betreibbar ist. Mit Hilfe einer derartigen elektrischen Maschine lässt sich beispielsweise eine Erzmühle, ein Transportband in der Schwerindustrie (z.B. zum Transport eines Erzes) oder ein Propeller eines Schiffes antreiben. Bei derartigen Antriebssystemen bzw. Antriebssträngen treten hohe Belastungen und/oder Schwingungen auf, welche den Betrieb des Antriebssystems über die Zeit negativ beeinflussen können. So kann es beispielsweise zu Lagerschäden oder Übertemperaturen kommen.

In einer Ausgestaltung des Verfahrens wird ein Big Data Ansatz verfolgt, er betrifft also einen Industrie 4.0 Ansatz bzw. einen IoT (Internet of Things) Ansatz. Hierzu können in der Antriebstechnik beispielsweise Smart Motor Zusatzboxen zum Einsatz kommen, welche eine motorbasiert Elektronik zum Zwecke des Condition Monitoring (CM) darstellen, die insbesondere energieautark, batteriegestützt von außen zugängliche Motordaten wie Drehzahl, Magnetfeld in eine Daten- und Informations Cloud kommunizieren.

In einer Ausgestaltung des Verfahrens werden im Verlauf eines Anlagenbetriebs bzw. eines Betriebes eines Antriebsstrangs abweichende Tendenzen z.B. durch sich erhöhende Schwingungsamplituden erkannt und Ausfälle zu vermeiden. Die veränderten Schwingungsamplituden können dabei in der Antriebsmaschine (z.B. durch Änderungen der Lagerung, der Luftspaltes durch auftretende Achsfehlausrichtungen, Veränderungen des Rotors, oder an einer anderen Stelle im Antriebsstrang auftreten.

In einer Ausgestaltung des Verfahrens werden zur Inbetriebnahme des Antriebsstranges Messfunktionalitäten zur Übermittelung von Übertragungsfunktionen mit insbesondere pseudostatischen Binärsignalen (PRPS) verwendet. Die Pseudorandom Binary Sequence (PRBS) ist ein binäres Signal, welches das Spektrum von weißem Rauschen approximiert und durch einen deterministischen Zufallsgenerator erzeugt wird. Ein PRBS lässt sich beispielsweise mit einem linear rückgekoppelten Schieberegister erzeugen. Es kann alternativ zum weißen Rauschen verwendet werden, wobei insbesondere die Reproduzierbarkeit des Signals vorteilhaft ist. Die Übertragungsfunktion kann auch im laufenden Betrieb des Antriebsstrands oder bei Wartungsarbeiten ermittelt werden. Die Übertragungsfunktion kann zwischen beliebigen Signalen ermittelt werden. So kann der Strom, das Drehmoment, die Drehzahl, oder auch ein Analog- Eingang mit einem CM-Signal (z.B.: Vibration, Beschleunigung, etc.) oder -Ausgang bei Vorgabe eines PRBS-Signals gesampelt werden. Die Transferfunktion ist dann der Quotient aus der Fouriertransformierten der Antwortfunktion (Ausgang) und der Fouriertransformierten der Vorgabefunktion (Eingang). Ein PRBS-Signal eignete sich zur Frequenzanalyse, da es ein ähnlich breites Frequenzspektrum wie weißes Rauschen enthält. Es ist auch möglich alternative Pseudo- oder Zufallszahlenfolgen zu generieren, welche die spektrale Dichte passend auf das erwartete Frequenzspektrum mappen (Rosa Rauschen: Rakhi R "Generation of Pink Noise using Pseudo Random Binary Sequence,). Die gleichzeitige Auswertung mehrere Übertragungsfunktionen ist möglich durch Nutzung von voneinander unabhängigen (unkorrelierten) PRBS Signalen.

Es kann sich die Frage ergeben, wie die einzelnen Testsignale gestaltet werden sollen. Verwendet man beispielsweise PRBS-Signale, ist es vorteilhaft nicht alle Eingangsgrößen gleichzeitig mit einer identischen PRBS-Folge zu beaufschlagen, da die Eingangsgrößen dann völlig miteinander korreliert wären. Besser geeignet sind unabhängige PRBS-Signale, PRBS-Folgen mit unterschiedlicher Periodendauer oder unterschiedlich initialisierte GBN-Signale.

In einer Ausgestaltung des Verfahrens kann ein aufgeprägtes PRBS Signal im Falle einer mitlaufenden Überwachung (Condition Monitoring / CM) je nach Anwendung verschieden in seiner Amplitude gewählt werden. So sollen sich PRBS Signale nicht hörbar äußern, aber auch nicht allzu nachteilig auf Gesamtwirkungsgrade niederschlagen. Da CM meist Veränderungen über längere Zeiträume erfasst, kann jedoch über die Mittelwertbildung auch ein kleines PRBS Signal vorteilhaft 1% des Nutzsignals zu rauschfreien Messungen und Auswertungen von Systemparametern des Antriebsstranges führen.

In einer Ausgestaltung des Verfahrens ist es auch möglich, sofern es die Applikation zulässt, im Betrieb der Maschine das PRBS Signal so zu gestalten, dass eine Messperiode ausreicht um die aktuellen, zu ermittelnden Systemparameter aus der gemessenen Übertragungsfunktion neu zu berechnen.

In einer Ausgestaltung des Verfahrens wird es ausgenutzt, dass ausgehend von gemessenen mechanischen Eigenschaften eines defektfreien Antriebsstranges Veränderungen im System durch Vergleichsmessungen feststellbar sind. Eine derartige Diagnose von "Beschädigungen" geschieht durch einen Vergleich mit dem Referenzfrequenzgang des nicht beschädigten Systems, der in der Praxis im Zuge der Inbetriebnahme des Antriebssystems ermittelt werden kann.

In einer Ausgestaltung des Verfahrens wird abhängig von einer Änderung der Übertragungsfunktion der Regelstrecke ein Regler verändert. Die Übertragungsfunktion wie auch die Regelstrecke und der Regler betreffen dabei den Antriebsstrang. Durch eine automatische Veränderung bzw. Optimierung des Reglers bzw. der Reglerparameter, kann eine Maschine bzw. ein Antriebsstrang auch bei Veränderungen der Regelstrecke optimiert werden. Dies betrifft beispielsweise im Betrieb auftretende Schwingungen. Schwingungen können z.B. durch Vibrationssensoren, z.B. an einem Lagergehäuse, aufgezeichnet werden. Insbesondere eignen sich der Schwingweg, die Schwinggeschwindigkeit und/oder die Schwingbeschleunigung als Messgrößen.

In einer Ausgestaltung des Verfahrens (des Betriebsverfahrens) wird abhängig von einer Änderung der Übertragungsfunktion der Regelstrecke eine Änderung des Antriebsstranges erkannt. Dies kann beispielsweise auch Unterkomponenten betreffen.

In einer Ausgestaltung des Verfahrens weist der Antriebsstrang Unterkomponenten auf, wobei derartige Antriebslösungen insbesondere folgende Unterkomponenten aufweisen können: Motor, Kupplung und/oder angetriebenes System wie z.B. Riemen, Kugelumlaufspindel, Walze, Prozesstechnischer Fluidkreis usw. Die Unterkomponenten können schwingfähige Systeme bilden. In einer Ausgestaltung eines Antriebsstranges ist zumindest ein geregelter Antrieb derart ausgestaltet, dass Regelmodelle und deren Parameter so gewählt werden können, dass kein instabiler Zustand des Systems auftritt.

In einer Ausgestaltung des Verfahrens erfolgt eine Überwachung eines Antriebsstranges, also das Condition Monitoring eines Antriebsstranges dadurch, dass mit Magnetfeld- und/oder Vibrations- und/oder Drehzahlsensoren und/oder Stromsensoren das Spektrum des bei Drehzahländerung (z.B. durch Gleichlaufschwankungen, Sprungfunktionen oder Hochlauf, aufmodulierte PRBS Strom/Drehzahlsprünge) sich ändernden Umrichtertakts dahingehend ausgewertet wird, dass Abweichungen der Übertragungsfunktion einer Antriebs-Reglerstrecke einer Information zum Zustand des Antriebsstranges bzw. dessen PID Reglerparametrierung zugänglich und korrigierbar werden. So kann eine Veränderung einer Regestrecke in einfacher Weise überwacht bzw. festgestellt werden.

In einer Ausgestaltung des Verfahrens kann also als Quelle für das erste Signal ein Magnetfeldsensor verwendet werden.

In einer Ausgestaltung des Verfahrens kann also als Quelle für das erste Signal ein Vibrationssensor verwendet werden.

In einer Ausgestaltung des Verfahrens kann also als Quelle für das erste Signal ein Drehzahlsensor verwendet werden.

In einer Ausgestaltung des Verfahrens kann mit antriebseignen Drehzahl-/Drehmoment-Signalen auch im Dauerbetrieb vermieden werden, dass sich der Antriebsstrang durch Änderungen im System Resonanzstellen annähert, indem durch automatische Neu-Auswahl der Reglerparameter, insbesondere der Regelparameter des Drehzahlreglers, diese Schwingneigung vermindert wird. Zumindest die Veränderung der charakteristischen Frequenzen und der zugehörigen Systemparameter sind vorteilhaft zu messen.

In einer Ausgestaltung des Verfahrens kann bei festgestellten Änderungen des Systems, insbesondere bei einer kritischen Änderung zumindest einer Resonanzstelle ein Alarm generiert bzw. ausgegeben werden. So kann beispielsweise ein Bediener aufgefordert sein Regelparameter zu ändern und/oder die Geschwindigkeit des Antriebsstrangs so zu ändern, dass die Resonanz nicht angefahren wird.

In einer Ausgestaltung des Verfahrens wird als Quelle für das erste Signal ein Strom- oder Spannungssensor verwendet. Derartige Signale stehen in einem Stromrichter des Antriebsstranges in der Regel sowieso zur Verfügung und müssen demnach nicht zusätzlich durch Sensoren bereitgestellt werden.

In einer Ausgestaltung des Verfahrens ist das erste Signal ein Anregungssignal, bzw. weist das erste Signal eine Anregungssignalform auf. Dabei können das Anregungssignal bzw. die Anregungssignalform eine bestimmte Form aufweisen. Die Form ist beispielsweise ein Sinus, ein Dreieck, einen Sprung, ein PRPS-Signal, etc. Das Signal wird beispielsweise vom Antrieb (z.B. dem Stromrichter bzw. dem Umrichter) erzeugt und liegt vorteilhaft in Industrieanwendungen vor, bei welchen drehzahlveränderliche Antriebe zum Einsatz kommen. Dies betrifft auch Anwendungsfälle bzw. gewissen Zeiten beispielsweise eines Prozesses, zu welchen Antriebe notwendig sind.

In einer Ausgestaltung des Verfahrens (Betriebsverfahrens) wird für das Erkennen der Änderung der Übertragungsfunktion ein Spektrum des ersten Signals ermittelt. Zur Ermittlung des Spektrums insbesondere eine FFT (Fast Foyer Transformation) verwendet.

In einer Ausgestaltung des Verfahrens betrifft das zweite Signal eine Gleichlaufschwankung und/oder eine Sprungfunktion und/oder einen Hochlauf und/oder einen aufmodulierten PRBS Strom. Damit ist das Verfahren seitig einsetzbar.

In einer Ausgestaltung des Verfahrens wird eine gespeicherte oder berechnete Übertragungsfunktion kontinuierlich überwacht. So kann eine Änderung der Regelungsstrecke kontinuierlich überwacht werden indem eine Änderung der Übertragungsfunktion erkannt wird.

In einer Ausgestaltung des Verfahrens kann mittels eines Bode-Plots oder einer ggfs. frequenzselektiven Auswertung des Übertragungsverhaltens eine Neuidentifikation des Systems erfolgen.

In einer Ausgestaltung des Verfahrens wird dieses in der Schwerindustrie (insbesondere bei einer Antriebsmaschine), bei einer Antriebsmaschine eines Schiffes oder bei einer Antriebsmaschine einer Papiermaschine verwendet bzw. zur Überwachung der selbigen genutzt. Gerade bei derartigen Anwendungen sind durch die hohen Belastungen Ausfälle zu erwarten bzw. Instandhaltungsmaßnahmen nur in bestimmten Rhythmen möglich, sodass die Kenntnis bezüglich einer Änderung der Maschine bzw. des Antriebssystems vorteilhaft ist.

Eine Vorrichtung zur Durchführung eines beschriebenen Verfahrens weist eine echtzeitfähige Schnittstelle zur Datenkommunikation auf. Auf diese Weise ist es möglich mittels der Vorrichtung auch akute Änderungen im beobachteten und überwachten System zu erkennen.

Die Vorrichtung ist insbesondere dann echtzeitfähig, wenn die Daten so schnell übertragen werden, dass eine rechtzeitige Auswertung und/oder ein rechtzeitiges Erkennen von Änderungen der Übertragungsfunktion und/oder ein rechtzeitiges Erkennen von Fehlern gewährleistet ist. Die Rechtzeitigkeit ist dabei von der Anwendung abhängig.

In einer Ausgestaltung der Vorrichtung weist diese eine Smart Sensor Boxen auf. Die Smart Sensor Box kann auch nachgerüstet werden. Mithilfe der Smart Sensor Box können beispielsweise Motordaten erfasst werden. Derartige Motordaten können eine CM-System übermittelt werden. So kann eine Smart Sensor Box beispielsweise zur Aufnahme folgender Werte ausgestaltet sein: Magnetfeld, Strom, Drehzahl, Vibration, etc. Derartige Werte können auch mittels eines Stromrichters und entsprechender Sensoren, welche an diesem angeschlossen sind, gesammelt werden. Ist ein Antrieb beispielsweise nicht an einem Umrichter bzw. Stromrichter angeschlossen so kann die Smart Sensor Box derartige Daten sammeln. Auch kann die Smart Sensor Box Funktionalitäten für oder von Umrichter betriebenen Antriebssystemen übernehmen. Bei Drehzahlvariationen (in einer Applikation vorliegend oder aufmoduliert) können die Verläufe von Umrichterpulsmustern und/oder deren charakteristische Spektren aufgezeichnet und/oder ausgewertet werden, um zu quantitativen Auswertungen des Antriebs im Betrieb zu gelangen, welche Rückschlüsse vor allem auf veränderte Systemeigenschaften zulassen, sowie diese aktuellen und historischen Systemeigenschaften in einer überlagerten Monitoring Funktion zur Verfügung zu stellen. So können beispielsweise mit einer Auswertung von PI-Reglerkreiszuständen eine Vielzahl von Regelkreisen ausgewertet werden.

Eine Ausgestaltung der Vorrichtung weist diese eine Smart Sensor Box für umrichterbetriebene elektrische Maschinen auf, wobei die Smart Sensor Box mindestens einem Magnetfeld- und/oder Strom-Sensor aufweist, wobei die Aufzeichnung die hochfrequenten Signalverläufe der Umrichtertaktung (bis ca. 100kHz bei magnetoresisitiven und ca. 40kHz bei Hall- basierten Magnetsensoren) betrifft. Es können auch die Umrichter Pulsmuster selbst und deren Verlauf aufgezeichnet werden. Diese Umrichterpulsmusterverläufe, welche für eine Anregungssignalform charakteristisch sind und beispielsweise aus der Inbetriebnahme-Parametrierung (des Reglerkreises) bekannt sind, werden in der Smart Sensor Box oder in einem abgesetzten Auswertungssystem ausgewertet. Nimmt beispielsweise die Smart Sensor Box eine Auswirkung eines Anregungssignals (also z.B. Schwingungssignale im Fall von Beschleunigungssensoren) eines Antriebsstrangs auf, ist es vorteilhaft das erzeugte Sollwert- Anregungssignal (z.B. der Form: Sinus, Dreieck, Sprung, PRBS, ...) als Signal der Auswerteinheit zur Smart Sensor Box zur Verfügung zu stellen. Dazu bieten sich digitale Signalstrecken an, um die Anregungs-Signalfolge zu übermitteln bzw. mindestens ein Signalpfad, um anzuzeigen, dass das Anregungssignal bzw. eine Signalfolge von Anregungen aktiv ist (IO Flag).

In einer weiteren Ausgestaltung der Vorrichtung kann ein externes Sensor Signal (beispielsweise Vibration, Magnetfeld, Zahnraddrehzahl, etc.) in einer Analog-Erfassungs-Schnittstelle des Antriebssystems geführt werden. Die Ermittlung der Übertragungsfunktion und der auszuwertenden Parameter erfolgen dann beispielsweise in der Steuerung. Die Steuerung ist dabei beispielsweise eine. Speicherprogrammierbare Steuerung (SPS) oder eine Steuerung/Regelung eines Stromrichters.

In einer weiteren Ausgestaltung der Vorrichtung werden Werte, welche von der Smart Sensor Box aufgenommen wurden einem Content Management (CM) System per Datenübertragung zur Weiterverarbeitung oder Speicherung zur Verfügung gestellt. Alternativ oder zusätzlich kann die ermittelte Übertragungsfunktion oder die Abweichung von der Soll-Übertragungsfunktion oder ein aktualisierte PID- Regler-Parametrierung gemeldet werden und /oder einem überlagerten CM-System und/ der der Antriebssteuerung zur Verfügung gestellt werden.

Die Erfindung wird nachfolgend beispielhaft anhand von Figuren beschrieben. Dabei zeigen:
- FIG 1: einen Antriebsstrang;
- FIG 2: eine Sprungantwort einer Regelstrecke;
- FIG 3: eine Übertragungsfunktion zweier schwingungsfähiger 2-Massen Systeme;
- FIG 4: Übertragungsfunktionen eines Drehzahlreglers eines Servoantriebs;
- FIG 5: eine zeitliche Abfolge der Drehzahl einer elektrischen Maschine bei einer Sprungfunktion der Drehzahl;
- FIG 6: eine zeitliche Abfolge der Drehzahl einer elektrischen Maschine bei einer linearen Rampe und nachfolgender Sprungfunktion für die Drehzahl und
- FIG 7: eine Übertragungsfunktion für eine Drehzahl zu einer Vibration.

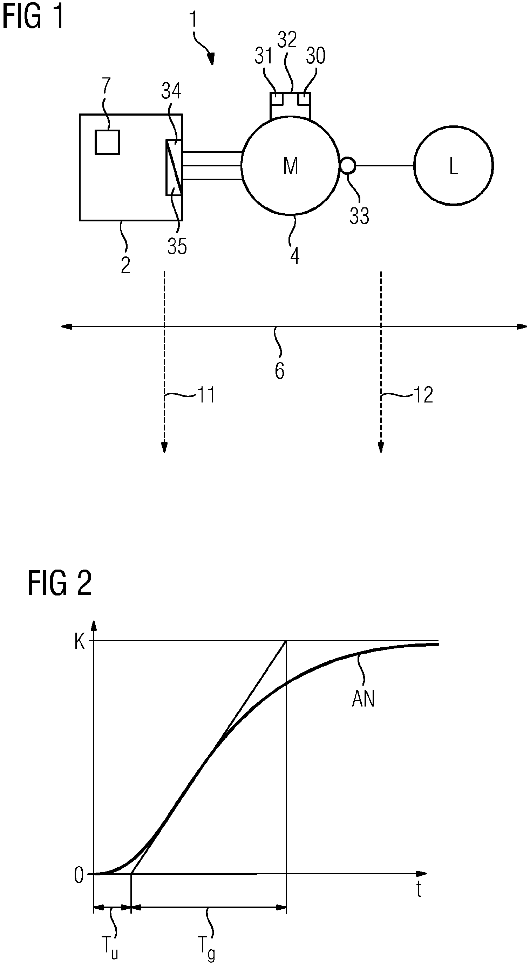

Die Darstellung nach FIG 1 zeigt einen Antriebsstrang 1 mit einer elektrischen Maschine (einer dynamoelektrischen Maschine) 4 an einer Last L, wobei die elektrische Maschine mittels eines Stromrichters 2 gespeist wird, wobei der Stromrichter einen Regler 7 zur Regelung der elektrischen Maschine aufweist. Der Stromrichter 2 weist auch einen Stromsensor 34 und einen Spannungssensor 35 auf. An der elektrischen Maschine 4 ist eine Vorrichtung 30 als Sensor angebracht. Diese Vorrichtung 30 kann auch als Smart Sensor Box bezeichnet werden, wenn dies beispielsweise zur Nachrüstung vorgesehen ist. Die Vorrichtung weist einen Magnetfeldsensor 31 und einen Vibrationssensor 32 auf. Die Vorrichtung 30 kann auch nur einen dieser Sensoren aufweisen oder einen Sensor anderer Art. Zur Feststellung der Drehzahl der elektrischen Maschine ist ein Drehzahlsensor 33 vorgesehen. Die elektrische Maschine 4 ist ein Teil einer Regelstrecke 6. Aus dieser Regelstrecke 6 werden Daten generiert, welche als ein erstes Signal 11 und als ein zweites Signal 12 Verwendung finden können.

Die Darstellung nach FIG 2 zeigt im Rahmen der Einstellung einer Regelstrecke eine Sprungantwort AN als ein Beispiel für ein heuristisches Verfahren zur Bestimmung von Reglerparametern. Dabei wird eine Sprungantwort AN einer Regelstrecke mit Wendetangente zur Bestimmung der Verstärkung K verwendet. Dabei ist über die Zeit t eine Verzugszeit Tᵤ und eine Ausgleichszeit T_{g} angegeben. Als Anregungssignal für eine Regelstrecke kann auch ein Zeitsignal mit einem Spektrum verwendet werden, welches ein weißes Rauschen hat oder eine PRBS-Folge (Pseudo-Rausch-Binär-Signal-Folge) darstellt, was allerdings in der Figur nicht dargestellt ist.

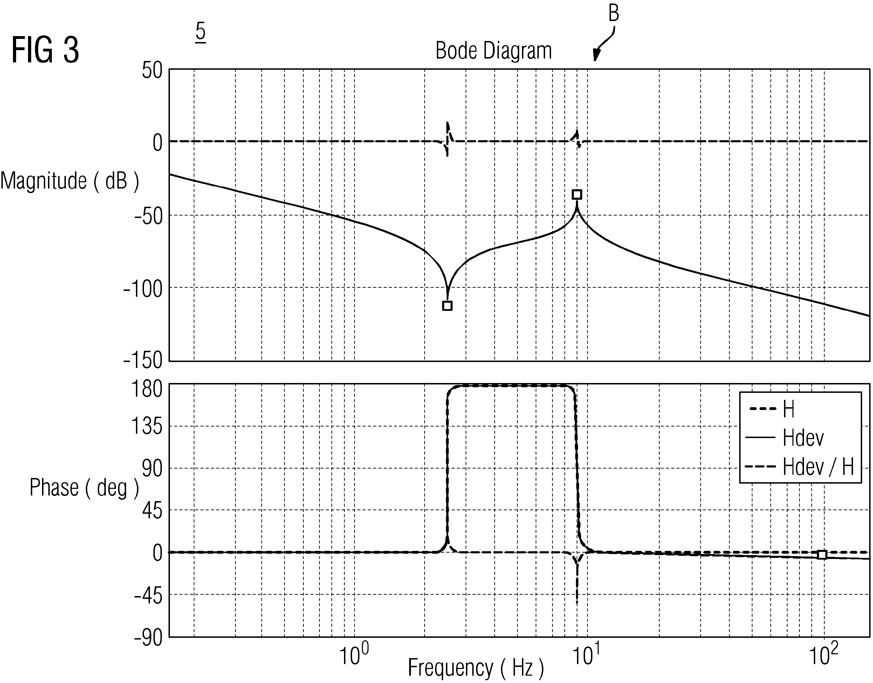

Die Darstellung nach FIG 3 zeigt exemplarisch eine Übertragungsfunktion zweier schwingfähiger 2-Massen Systeme mit einer Ausgangsübertragungsfunktion H und einer angenommenen Abweichung der Übertragungsfunktion Hdev. Es ist die Amplitude (Magnitude (dB)) wie auch die Phasenlage (Phase(deg)) über der Frequenz (Frequency (Hz)) dargestellt. Bei Hdev ist die Grundfrequenz w0, die Koppelfrequenz w1, die Dämpfungsglieder um jeweils 1% abweichend. Zudem tritt in Hdev eine angenommene Totzeit von 100µs auf.

Ein Bode Diagramm B z.B. eines einfachen 2-Masse Modells, kann zur Auswertung der Parameter J1, J2 für die Trägheit bzw. den Parameter c aus den Frequenzen fL und fR dienen.

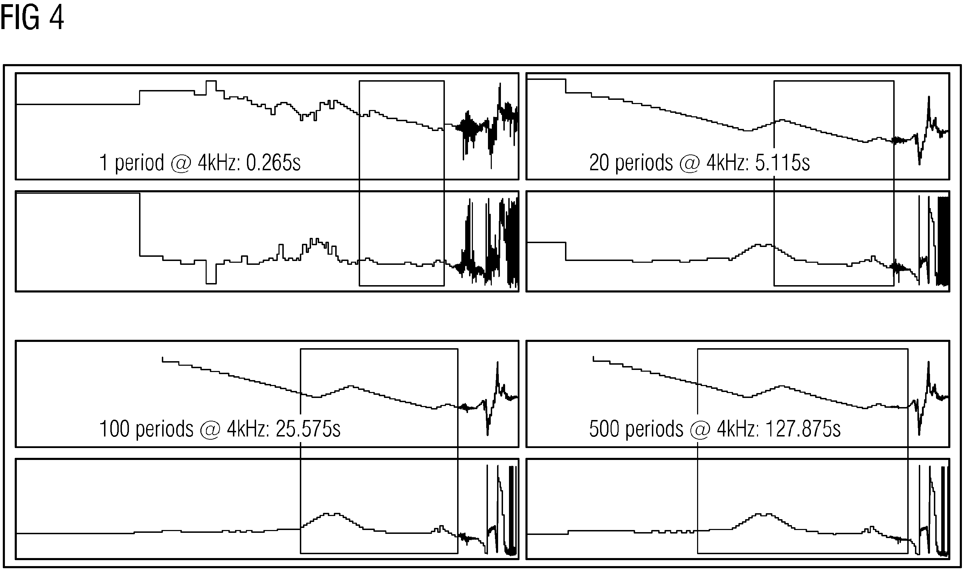

Die Darstellung nach FIG 4 zeigt die Übertragungsfunktion eines Drehzahlreglers eines Servoantriebs. Diese wird aus dem aktuellen Drehmoment zur aktuellen Drehzahl bei Anliegen des PRBS als Strom-Sollwertvorgabe für eine zunehmende Anzahl an Mittelungen für ein 2- Massensystem ermittelt. Die FIG 4 gibt vier Darstellungen wieder, welche sich in ihrer Periode unterscheiden (1, 20, 100 und 500).

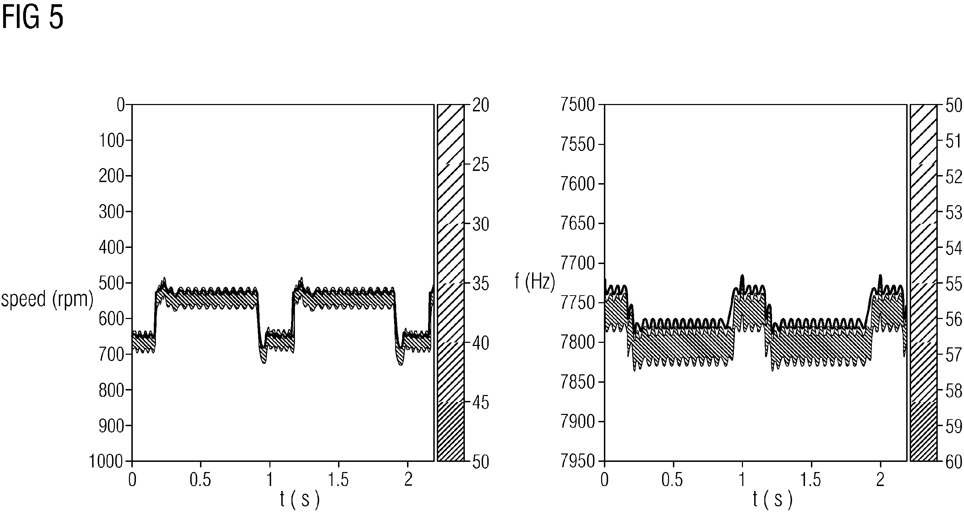

Die Darstellung nach FIG 5 zeigt links eine zeitliche Abfolge einer Drehzahl D einer elektrischen Maschine (mit einem Drehzahlgeber) mit einer Sprungfunktion der Drehzahl (600rpm +/-60rpm) mit einem PI-Regler bei P=10 und I=15. Rechts ist das zugehörige Pulsmuster (hier Vibrationsdaten bei einer aufgenommenen Frequenz f) des Umrichters zur Erzeugung des Drehzahlverlaufs dargestellt. Mit einer Sensoreinrichtung, wie z.B. einer Smart Sensor Box, welche auch nachrüstbar sein kann, ist es möglich in einem von der Sensoreinrichtung zugänglich messbaren Zeit/Frequenzverlauf z.B. eine Vibration und/oder ein Magnetfeld zu messen. Verschiedene Einstellungen eines Reglers (z.B. eines PI-Reglers) eines Stromrichters oder eines Steuerungsgerätes können sich beispielsweise bei verschiedenen Drehzahlverläufen in einem für eine Sensoreinrichtung zugänglich messbaren Zeit/Frequenzverlauf z.B. der Vibration, aber auch dem Magnetfeld äußern. Dies zeigt sich beispielsweise auch, wenn man die Drehzahlspektren und exemplarisch die Vibrationsspektren in der Nähe einer Umrichter Takt-Frequenz (z.B. 8kHz) gegenüberstellt, wie z.B. bei einer elektrischen Maschine (z.B. eine Asynchronmaschine oder eine Synchronmaschine) beim Umrichterbetrieb. Für eine vereinfachte Messung kann dies ohne Lastmaschine im lastlosen Zustand bei geberloser Regelung für verschiedene Anregungssignalformen und PI-Regler-Parameter erfolgen.

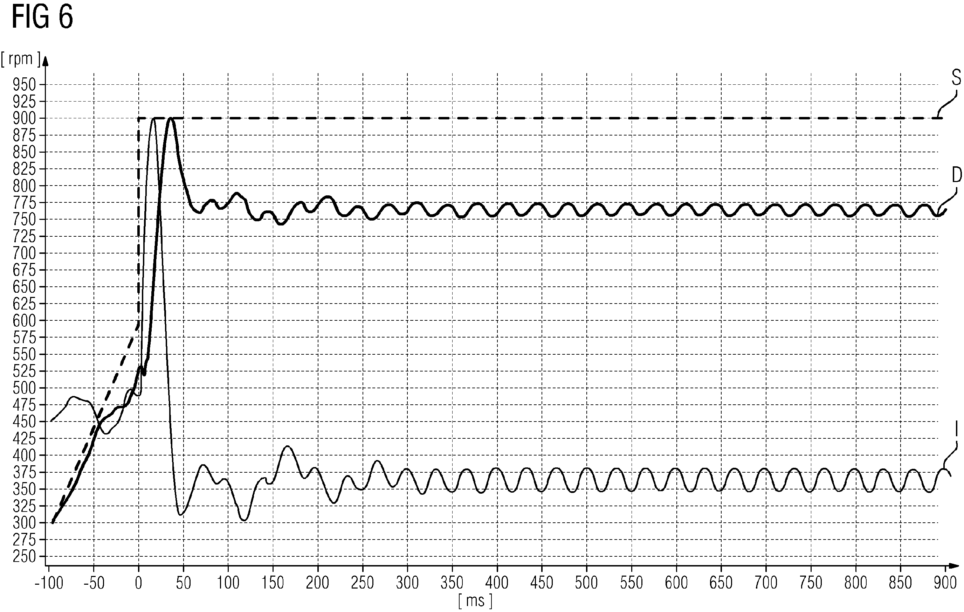

Die Darstellung nach FIG 6 zeigt eine zeitliche Abfolge (in Millisekunden) der Ist-Drehzahl D einer elektrischen Maschine (Drehzahlgeber) und vom Moment, welches proportional zum Strom I ist, bei einer linearer Rampe der Soll-Drehzahl S auf 600rpm und nachfolgender Sprungfunktion der Soll-Drehzahl S mit 600rpm +/- 300rpm bei Parametereinstellungen von P=10 und I=15 für den PI-Regler.

Für verschiedene weitere Einstellungen könnten weitere Signale aufgezeichnet werden, die einen unterschiedlichen Verlauf des Pulsmusters (z.B. Vibrationsdaten), abhängig vom Drehzahlverlauf, zeigen würden:
- zeitliche Abfolge der Drehzahl einer elektrischen Maschine (Drehzahlgeber) mit P=7/ I=30ms bei einer Dreiecksfahrt auf 600rpm+/-300rpm;
- zeitliche Abfolge der Drehzahl einer elektrischen Maschine (Drehzahlgeber) mit P=7/ I=30ms bei linearer Rampe auf 600rpm und nachfolgender Stufenfahrt von 600rpm auf 900rpm;
- zeitliche Abfolge der Drehzahl einer elektrischen Maschine (Drehzahlgeber) mit P=1/ I=180ms bei linearer Rampe auf 600rpm und Stufenfahrt von 600rpm auf 900rpm;
- zeitliche Abfolge der Drehzahl einer elektrischen Maschine (Drehzahlgeber) mit P=10/ I=25ms bei linearer Rampe auf 600rpm und Stufenfahrt von 600rpm auf 900rpm;
- zeitliche Abfolge der Drehzahl einer elektrischen Maschine (Drehzahlgeber) mit P=10/ I=15ms bei linearer Rampe auf 600rpm und Stufenfahrt von 600rpm auf 900rpm;
- zeitliche Abfolge der Drehzahl einer elektrischen Maschine (Drehzahlgeber) mit einer linearen Rampe auf 600rpm und Pseudostatistischem Rauschen von 600rpm +/-60rpm;

Bei zu hohem P Anteil und/oder kleinem I Anteil können messbare Resonanzschwingungen sowohl in der Drehzahl als auch in der Umrichtertaktung auftreten. Zur Auswertung und/oder Messung können auch Änderungen bei höheren harmonischen der Grunddrehzahl-Frequenz herangezogen werden.

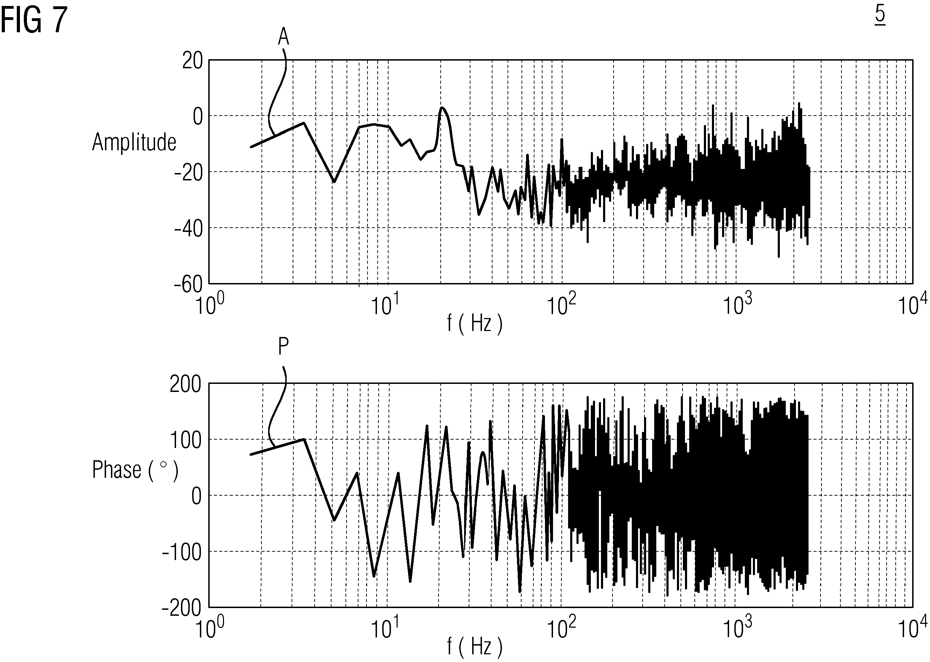

Die Darstellung nach FIG 7 zeigt eine Übertragungsfunktion 5 zur Drehzahl mit einer Amplitude A und einer Phase P zu Vibration bei Anregung mit PRBS 600rpm+/-60rpm. Die Amplitude zeigt eine Resonanzstelle bei 20Hz.

## Patentansprüche

1. Betriebsverfahren eines Antriebsstranges (1), wobei der Antriebsstrang (1) zumindest einen Stromrichter (2) aufweist, wobei ein erstes Signal (11), welches vom Takt des Stromrichters (2) abhängt, aufgenommen wird, wobei ein zweites Signal (12), welches von einer Drehzahl (D) einer elektrischen Maschine (4) abhängt, aufgenommen wird, wobei eine Übertragungsfunktion (5) einer Regelstrecke (6) ermittelt wird, wobei die Regelstrecke (6) den Antriebsstrang (1) aufweist, wobei eine Änderung der Übertragungsfunktion (5) erkannt wird.

2. Betriebsverfahren nach Anspruch 1, wobei abhängig von einer Änderung der Übertragungsfunktion (5) der Regelstrecke (6) ein Regler (7) verändert wird.

3. Betriebsverfahren nach Anspruch 1 oder 2, wobei abhängig von einer Änderung der Übertragungsfunktion (5) der Regelstrecke (6) eine Änderung des Antriebsstranges (1) erkannt wird.

4. Betriebsverfahren nach einem der Ansprüche 1 bis 3, wobei als Quelle für das erste Signal (11) ein Magnetfeldsensor (31) verwendet wird.

5. Betriebsverfahren nach einem der Ansprüche 1 bis 4, wobei als Quelle für das erste Signal (11) ein Vibrationssensor (32) verwendet wird.

6. Betriebsverfahren nach einem der Ansprüche 1 bis 5, wobei als Quelle für das erste Signal (11) ein Drehzahlsensor (33) verwendet wird.

7. Betriebsverfahren nach einem der Ansprüche 1 bis 6, wobei als Quelle für das erste Signal (11) ein Strom- oder Spannungssensor (34,35) verwendet wird.

8. Betriebsverfahren nach einem der Ansprüche 1 bis 7, wobei für das Erkennen der Änderung der Übertragungsfunktion (5) ein Spektrum des ersten Signals (11) ermittelt wird.

9. Betriebsverfahren nach einem der Ansprüche 1 bis 8, wobei das zweite Signal (12) eine Gleichlaufschwankung und/oder eine Sprungfunktion und/oder einen Hochlauf und/oder einen aufmodulierten PRBS Strom betrifft.

10. Betriebsverfahren nach einem der Ansprüche 1 bis 9, wobei die Übertragungsfunktion (5) kontinuierlich überwacht wird.

11. Betriebsverfahren nach einem der Ansprüche 1 bis 10, wobei eine Antriebsmaschine (4) in der Schwerindustrie, eine Antriebsmaschine eines Schiffes oder eine Antriebsmaschine einer Papiermaschine überwacht wird.

12. Vorrichtung (30) zur Durchführung eines Verfahrens nach einem der Ansprüche 1 bis 10, wobei die Vorrichtung (30) eine echtzeitfähige Schnittstelle zur Datenkommunikation aufweist.

13. Vorrichtung (30) nach Anspruch 12, wobei die Vorrichtung (30) eine Smart Sensor Boxen aufweist.
